(19) Europäisches Patentamt
European Patent Office
Office européen des brevets

(11) Publication number : **0 505 155 A1**

(12) # EUROPEAN PATENT APPLICATION

(21) Application number : **92302314.7**

(51) Int. Cl.$^5$ : **G03C 1/498,** G03F 7/095

(22) Date of filing : **18.03.92**

(30) Priority : **22.03.91 JP 81277/91**

(43) Date of publication of application :
**23.09.92 Bulletin 92/39**

(84) Designated Contracting States :
**DE FR GB**

(71) Applicant : **CANON KABUSHIKI KAISHA**
**30-2, 3-chome, Shimomaruko, Ohta-ku**
**Tokyo (JP)**

(72) Inventor : **Fukui, Tetsuro, c/o Canon Kabushiki Kaisha**
**30-2, 3-chome, Shimomaruko**
**Ohta-ku, Tokyo (JP)**
Inventor : **Tanaka, Hiromi, c/o Canon Kabushiki Kaisha**
**30-2, 3-chome, Shimomaruko**
**Ohta-ku, Tokyo (JP)**
Inventor : **Kagami, Kenji, c/o Oriental Photo Ind. Co., Ltd.**
**11-3 Ohkubo 1-chome**
**Shinjuku-ku, Tokyo (JP)**
Inventor : **Suzuki, Masao, c/o Oriental Photo Ind. Co., Ltd.**
**11-3 Ohkubo 1-chome**
**Shinjuku-ku, Tokyo (JP)**

(74) Representative : **Beresford, Keith Denis Lewis et al**
**BERESFORD & Co. 2-5 Warwick Court High Holborn**
**London WC1R 5DJ (GB)**

(54) **Heat-developable masking layer.**

(57) A head-processable masking layer for a photo polymerisable layer is disclosed. The photosensitive masking layer contains at least an organic silver salt, a silver halide or a silver halide forming agent, a reducing agent and a metal chelate compound. Also, an image forming method is disclosed which used the heat-developable photosensitive material.

EP 0 505 155 A1

## BACKGROUND OF THE INVENTION

### Field of the invention

The present invention relates to a heat-developable photosensitive material containing an organic silver salt. It also relates to an image forming method making use of such a heat-developable photosensitive material.

### Related Background Art

Hitherto known silver salt photography making use of a photosensitive silver halide can achieve excellent sensitivity and gradation, and is a recording technique having been most widely put into practical use. This photography, however, makes use of a wet process in the processing steps such as developing, fixing and washing, and hence has many problems on operability and safety such that it takes much labor and time for the processing and chemicals used for the processing may give anxiety for influence on human bodies.

As a countermeasure therefor, researches have been extensively made in relation to dry processing photography, as disclosed in Japanese Patent Publications No. 43-4921, No. 43-4924, etc. These disclosures are concerned with a technique in which a photosensitive silver halide is used in an amount corresponding to the amount required for a catalyst and a non-photosensitive organic silver salt is used as,an image forming agent. The mechanism by which the organic silver salt acts as an image forming agent can be explained as follows: (1) A silver nucleus is produced from a photosensitive silver halide as a result of exposure, and it forms a latent image. (2) The silver nucleus serves as a catalyst, an organic silver salt and a reducing agent cause oxidation-reduction reaction upon heating, and the organic silver salt is reduced to metallic silver, which forms a visible image.

As an example of methods of utilizing such a heat-developable photosensitive material, Japanese Patent Application Laid-open No. 55-50246 discloses a method of use as a mask. In this method, a silver image is used as a mask. As a photosensitive material that can obtain a polymer image having much better contrast than the case where the silver image is utilized as a mask, Japanese Patent Application Laid-open No. 3-135564, proposed by the present assignee, discloses a photosensitive material capable of forming an image with a good contrast by utilizing light-absorbing properties of a light-absorbing organic compound formed as a result of the oxidation of a reducing agent.

Because of an advantage of the heat-developable photosensitive material over the wet-process silver salt photosensitive material in view of the fact that the former requires no wet processing, it has been sought to make photosensitivity and raw stock stability comparable to, or more improve them than, those of the wet-process photosensitive materials (the raw stock stability is the properties by which photosensitive materials can be stored in such a state that its photographic performance immediately after manufacture is retained as it is).

## SUMMARY OF THE INVENTION

The present invention was made taking account of such existing circumstances. An object thereof is to provide a heat-developable (dry-process silver salt) photosensitive material having a high photosensitivity and promising a superior raw stock stability.

The heat-developable photosensitive material of the present invention comprises a support and provided thereon a photosensitive layer containing at least an organic silver salt, a silver halide or a silver halide forming agent, a reducing agent and a metal chelate compound.

In the heat-developable photosensitive material of the present invention, the photosensitive layer described above may contain a polymerizable polymer precursor and a photopolymerization initiator. Alternatively, a polymerizing layer containing a polymerizable polymer precursor and a photopolymerization initiator may be provided in addition to the photosensitive layer described above.

The image forming method of the present invention comprises subjecting the above heat-developable photosensitive material to imagewise exposure and heating, and further optionally to polymerization exposure.

## BRIEF DESCRIPTION OF THE DRAWINGS

Fig. 1 is a graph to show a photosensitivity performance of a photosensitive material A produced in Example 1 of the present invention.

Fig. 2 is a graph to show photosensitivity performances of photosensitive materials J, K and L produced in Example 4 of the present invention.

## DESCRIPTION OF THE PREFERRED EMBODIMENTS

The heat-developable photosensitive material of the present invention comprises a support and a photosensitive layer provided thereon. The photosensitive layer contains an organic silver salt, a silver halide, a reducing agent and a metal chelate compound. In the present invention, the silver halide contained in the photosensitive layer may be replaced with a silver halide forming agent.

In the chelate compound used in the present invention, the central metal may preferably be a transition metal such as Zn, Cu, Ni, Co, Mn, Pd or Zr. The chelate compound may also preferably have a sulfur atom as its ligand.

Preferable chelate compounds are shown below.

(i) A thiosalicylaldoxime compound represented by the following Formula (1):

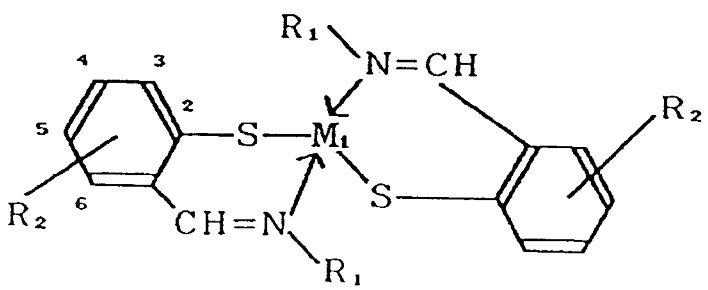

(1)

$R_1$ represents a hydrogen atom, a hydroxyl group, an alkyl group or an aryl group. The two $R_1$'s may be the same or different from each other and may combine with each other. $R_2$ represents an alkyl group, a halogen atom, a hydrogen atom or a nitro group, or may form a condensed ring together with the benzene ring. The two $R_2$'s may be the same or different from each other. The central atom $M_1$ represents Cu, Ni, Co or Pd.

Preferable examples of the compound of Formula (1) are shown in Table 1 below.

Table 1

| No. | $R_1$ | $R_2$ | $M_1$ |
| --- | --- | --- | --- |
| M-1-1 | OH | H | Cu |
| M-1-2 | OH | H | Ni |
| M-1-3 | H | $4-C_2H_5$ | Ni |
| M-1-4 | $C_2H_5$ | 5-Cl | Ni |
| M-1-5 | $i-C_3H_7$ | H | Co |
| M-1-6 | $n-C_6H_{13}$ | $4-CH_3$ | Ni |
| M-1-7 | $n-C_6H_{13}$ | $4-CH_3$ | Pd |
| M-1-8 | $C_6H_5$ | H | Ni |
| M-1-9 | H | $5,6-C_4H_4$ | Ni |
| M-1-10 | $-CH_2-$ | $4-NO_2$ | Ni |

(ii) A salicylaldoxime compound represented by the following Formula (2):

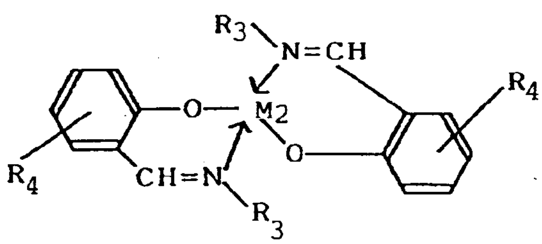

(2)

$R_3$ represents a hydrogen atom, a hydroxyl group, an alkyl group or an aryl group. The two $R_3$'s may be the same or different from each other, and may combine with each other. $R_4$ represents a hydrogen atom, a halogen atom, an alkyl group or a nitro group, or may form a condensed ring together with the benzene ring. The two $R_4$'s may be the same or different from each other. $M_2$ represents Cu, Ni, Co or Pd.

Preferable examples of the compound of Formula (2) are shown in Table 2 below.

Table 2

| No. | $R_3$ | $R_4$ | $M_2$ |
|---|---|---|---|
| M-2-1 | H | H | Cu |
| M-2-2 | $CH_3$ | H | Ni |
| M-2-3 | OH | $5-C_2H_5$ | Cu |
| M-2-4 | $C_2H_5$ | $5-C_2H_5$ | Ni |
| M-2-5 | $C_3H_7$ | 4-Cl | Ni |
| M-2-6 | $(CH_2)_5CH_3$ | $4-CH_3$ | Ni |
| M-2-7 | $(CH_2)_{11}CH_3$ | $5,6-C_4H_4$ | Ni |
| M-2-8 | $i-C_3H_7$ | $5,6-C_4H_4$ | Co |
| M-2-9 | OH | $4-C_3H_7$ | Co |
| M-2-10 | OH | H | Pd |
| M-2-11 | $-CH_2-$ | $4-NO_2$ | Ni |
| M-2-12 | $-CH_2-$ | $4-NO_2$ | Cu |

(iii) A thioacetothiophenon compound represented by the following Formula (3):

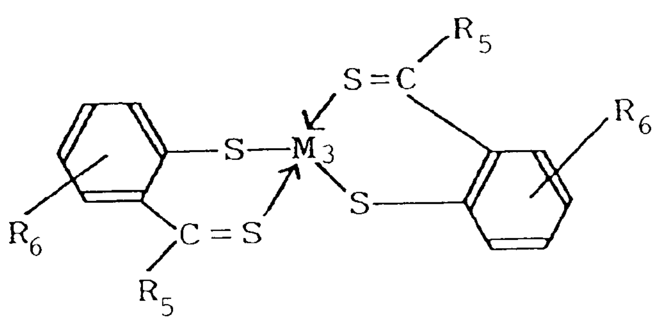

(3)

$R_5$ represents an alkyl group or an aryl group. The two $R_5$'s may be the same or different from each other. $R_5$ represents a hydrogen atom, a halogen atom, an alkyl group, an aryl group or a nitro group, or may form a condensed ring together with the benzene ring. The two $R_5$'s may be the same or different from each other. $M_3$ represents Cu, Ni or Pd.

Preferable examples of the compound of Formula (3) are shown in Table 3 below.

Table 3

| No. | $R_5$ | $R_6$ | $M_3$ |
|---|---|---|---|
| M-3-1 | $CH_3$ | H | Ni |
| M-3-2 | $C_2H_5$ | 4-$CH_3$ | Ni |
| M-3-3 | $C_6H_5$ | 4-$C_2H_5$ | Ni |
| M-3-4 | 4'-$(CH_3)_2N$-$C_6H_4$ | H | Ni |
| M-3-5 | 4'-Cl-$C_6H_4$- | 4-$CH_3$ | Ni |
| M-3-6 | $CH_3$ | 4-$CH_3$ | Pd |
| M-3-7 | $C_2H_5$ | 4-Cl | Pd |
| M-3-8 | $CH_3$ | 4-$NO_2$ | Ni |
| M-3-9 | $C_6H_5$ | $C_6H_5$ | Ni |

(iv) An acetothiophenon compound represented by the following Formula (4):

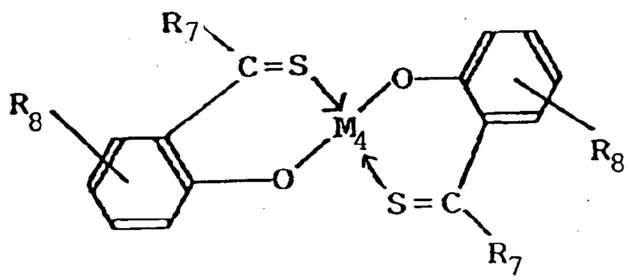

(4)

$R_7$ represents an alkyl group or an aryl group. The two $R_7$'s may be the same or different from each other. $R_8$ represents a hydrogen atom, a halogen atom, an alkyl group, or an aryl group,-or may form a condensed ring together with the benzene ring. The two $R_8$'s may be the same or different from each other. $M_4$ represents Cu, Ni or Pd.

Preferable examples of the compound of Formula (4) are shown in Table 4 below.

Table 4

| No. | $R_7$ | $R_8$ | $M_4$ |
|---|---|---|---|
| M-4-1 | $CH_3$ | H | Cu |
| M-4-2 | $C_2H_5$ | $4-CH_3$ | Cu |
| M-4-3 | $CH_3$ | H | Ni |
| M-4-4 | $C_3H_7$ | $4-CH_3$ | Ni |
| M-4-5 | $(CH_2)_5CH_3$ | $C_6H_5$ | Ni |
| M-4-6 | $(CH_2)_7CH_3$ | $C_6H_5$ | Ni |
| M-4-7 | $C_2H_5$ | $5,6-C_4H_4$ | Ni |
| M-4-8 | $CH_3$ | H | Pd |
| M-4-9 | $(CH_2)_5CH_3$ | 4-Cl | Pd |

(v) An oxyxanthione compound represented by the following Formula (5):

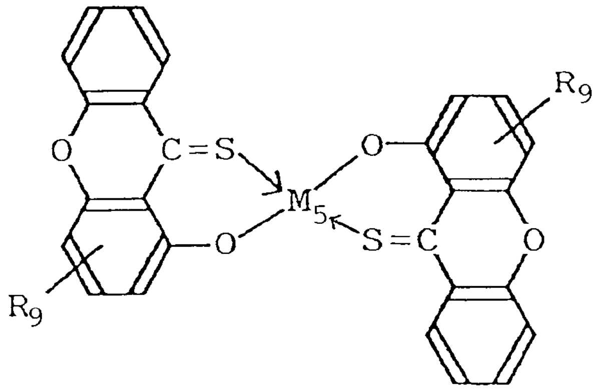

(5)

$R_9$ represents a hydrogen atom, a halogen atom or an alkyl group. The two $R_9$'s may be the same or different from each other. $M_5$ represents Cu or Ni.

Preferable examples of the compound of Formula (5) are shown in Table 5 below.

Table 5

| No. | $R_9$ | $M_5$ |
|---|---|---|
| M-5-1 | H | Cu |
| M-5-2 | H | Ni |
| M-5-3 | 4-$CH_3$ | Ni |

(vi) A pyromeconic acid compound represented by the following Formula (6):

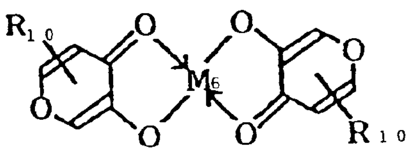

(6)

$R_{10}$ represents a hydrogen atom or an alkyl group. The two $R_{10}$'s may be the same or different from each other. $M_6$ represents Cu, Ni, Co or Mn.

Preferable examples of the compound of Formula (6) are shown in Table 6 below.

Table 6

| No. | $R_{10}$ | $M_6$ |
|---|---|---|
| M-6-1 | H | Mn |
| M-6-2 | H | Ni |
| M-6-3 | 2-$C_2H_5$ | Ni |

(vii) A bisdithiol compound represented by the following Formula (7):

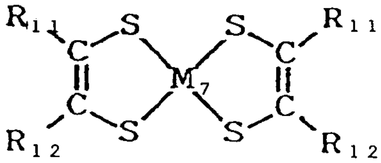

(7)

$R_{11}$ and $R_{12}$ each represent a substituted or unsubstituted alkyl group, an acyl group or an aryl group. The two $R_{11}$'s and two $R_{12}$'s may each be the same or different from each other. $R_{11}$ and $R_{12}$ may combine to form an aromatic ring. $M_7$ represents Cu, Ni, Co or Pd. In this instance, $M_7$ may have a negative charge and may

have a counter cation.

Preferable examples of the compound of Formula (7) are shown in Table 7 below.

Table 7

| No. | $R_{11}$ | $R_{12}$ | $M_7$ |
|---|---|---|---|
| M-7-1 | $C_6H_5$ | $C_6H_5$ | Cu |
| M-7-2 | $C_6H_5$ | $C_6H_5$ | Ni |
| M-7-3 | p-$(C_2H_5)_2N$-$C_6H_4$ | $C_6H_5$ | Ni |
| M-7-4 | p-$(CH_3)_2N$-$C_6H_4$ | $C_6H_5$ | Ni |
| M-7-5 | $CH_3CO$ | $CH_3CO$ | Ni |
| M-7-6 | p-$CH_3O$-$C_6H_4$ | p-$CH_3$-$C_6H_4$ | Ni |
| M-7-7 | $C_6H_2Cl_3$ | $C_6H_2Cl_3$ | Ni |
| M-7-8 | $C_6H_2Cl_3$ | $C_6H_3Cl_2$ | Ni |

(viii) A mercaptobenzoazole compound represented by the following Formula (8):

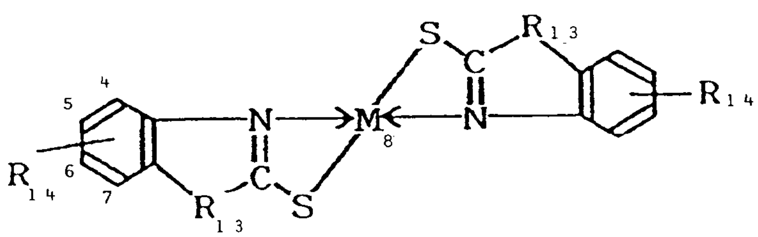

(8)

$R_{13}$ represents a sulfur atom, a substituted or unsubstituted amino group, an oxygen atom or a thioketone group. $R_{14}$ represents a hydrogen atom, an alkyl group, a halogen atom or an amino group. The two $R_{14}$'s may be the same or different from each other. $M_8$ represents Zn, Cu or Ni.

Preferable examples of the compound of Formula (8) are shown in Table 8 below.

Table 8

| No. | $R_{13}$ | $R_{14}$ | $M_8$ |
|---|---|---|---|
| M-8-1 | O | H | Zn |
| M-8-2 | O | 5-$CH_3$ | Zn |
| M-8-3 | S | H | Ni |
| M-8-4 | S | 5-Cl | Ni |
| M-8-5 | S | 5-$CH_3$ | Ni |
| M-8-6 | S | 4-$CH_3$ | Ni |
| M-8-7 | S | 5-$(CH_3)_2N$ | Ni |
| M-8-8 | NH | H | Ni |
| M-8-9 | NH | 5-$CH_3$ | Ni |
| M-8-10 | $NCH_3$ | H | Ni |
| M-8-11 | NH | 6-$C_2H_5$ | Ni |
| M-8-12 | C=S | H | Ni |

(ix) A hydroxamic acid compound represented by the following Formula (9):

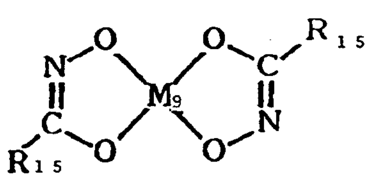

(9)

$R_{15}$ represents an alkyl group, an aryl group or a styryl group. The two $R_{15}$'s may be the same or different from each other. $M_9$ represents Cu, Ni or Co.

Preferable examples of the compound of Formula (9) are shown in Table 9 below.

Table 9

| No. | $R_{15}$ | $M_9$ |
|---|---|---|
| M-9-1 | $C_3H_7$ | Cu |
| M-9-2 | $C_6H_5$ | Ni |
| M-9-3 | $C_6H_5CH{=}CH-$ | Ni |
| M-9-4 | $Cl-C_6H_4CH{=}CH-$ | Ni |

(x) A biscyclopentadiene compound represented by the following Formula (10):

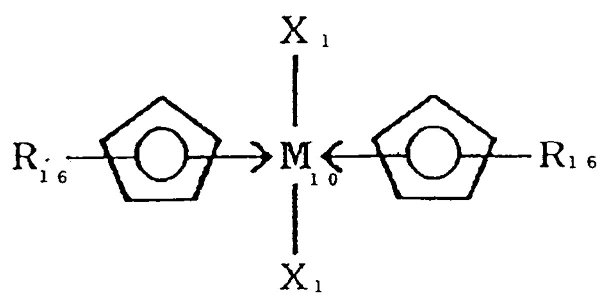

(10)

$R_{16}$ represents a hydrogen atom, a halogen atom, an alkyl group, an acyl group or an aryl group. The two $R_{16}$'s may be the same or different from each other. $M_{10}$ represents Ni or Zr. $X_1$ represents a halogen atom. $X_1$ may be absent.

Preferable examples of the compound of Formula (10) are shown in Table 10 below.

Table 10

| No. | $R_{16}$ | $M_{10}$ | $X_1$ |
|---|---|---|---|
| M-10-1 | H | Ni | – |
| M-10-2 | H | Zr | Cl |
| M-10-3 | $CH_3CO$ | Ni | – |
| M-10-4 | Cl | Ni | – |
| M-10-5 | $C_3H_7$ | Ni | – |

(xi) A nitrosohydroxylamine compound represented by the following Formula (11):

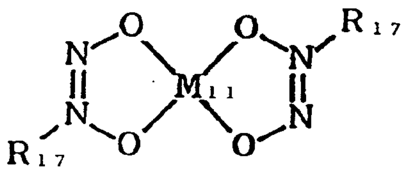

(11)

$R_{17}$ represents an alkyl group or an aryl group. The two $R_{17}$'s may be the same or different from each other. $M_{11}$ represents Cu, Ni or Co.

Preferable examples of the compound of Formula (11) are shown in Table 11 below.

Table 11

| No. | $R_{17}$ | $M_{11}$ |
|---|---|---|
| M-11-1 | $C_3H_7$ | Cu |
| M-11-2 | $C_3H_7$ | Ni |
| M-11-3 | $p-(CH_3)_2N-C_6H_4-$ | Cu |
| M-11-4 | $p-(CH_3)_2N-C_6H_4-$ | Ni |

(xii) A dioxime compound represented by the following Formula (12):

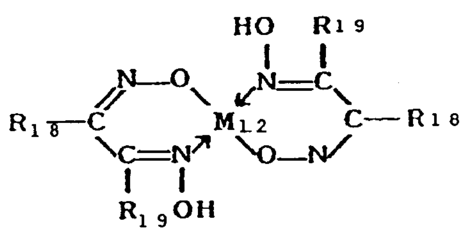

(12)

$R_{18}$ and $R_{19}$ each represent an alkyl group or an aryl group. The two $R_{18}$'s and two $R_{19}$'s may each be-the same or different from each other. $M_{12}$ represents Ni.

Preferable examples of the compound of Formula (12) are shown in Table 12 below.

Table 12

| No. | $R_{18}$ | $R_{19}$ | $M_{12}$ |
|---|---|---|---|
| M-12-1 | $CH_3$ | $CH_3$ | Ni |
| M-12-2 | $C_2H_5$ | $C_2H_5$ | Ni |
| M-12-3 | $C_6H_5$ | $C_6H_5$ | Ni |

(xiii) A glyoxime compound represented by the following Formula (13):

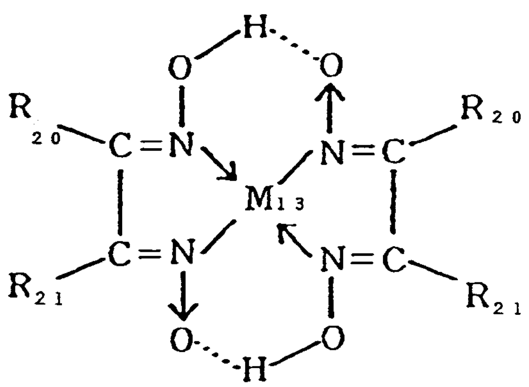

(13)

$R_{20}$ and $R_{21}$ each represent an alkyl group, amino group, an aryl group or a furan group. The two $R_{20}$'s and two $R_{21}$'s may each be the same or different from each other. $R_{20}$ and $R_{21}$ may combine to form an alicyclic compound. $M_{13}$ represents Ni.

Preferable examples of the compound of Formula (13) are shown in Table 13 below.

Table 13

| No. | $R_{20}$ | $R_{21}$ |
|---|---|---|
| M-13-1 | $NH_2$ | $NH_2$ |
| M-13-2 | $C_6H_5$ | $C_6H_5$ |
| M-13-3 | 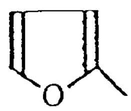 | 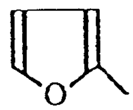 |
| M-13-4 | $-CH_2-CH_2-$ | $-CH_2-CH_2-$ ($R_{20}$ and $R_{21}$ combine to form a ring.) |
| M-13-5 | $CH_3$ | $CH_3$ |
| M-13-6 | $C_2H_5$ | $C_2H_5$ |

(xiv) A compound represented by the following Formula (14):

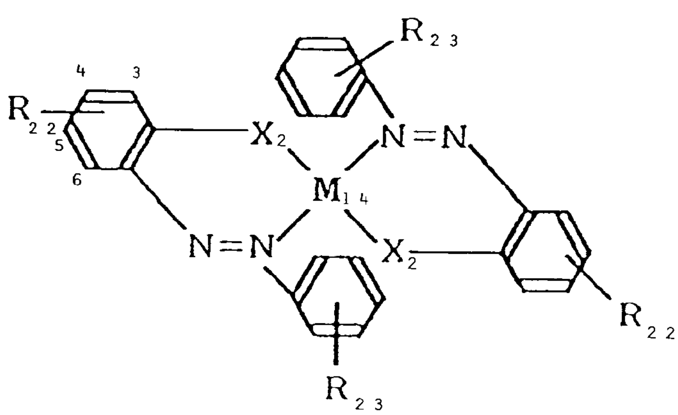

(14)

$R_{22}$ and $R_{23}$ each represent a hydrogen atom, a halogen atom or an alkyl group. The two $R_{22}$'s and two $R_{23}$'s may each be the same or different from each other. $X_2$ represents an oxygen atom or a sulfur atom. $M_{14}$ represents Ni.

Preferable examples of the compound of Formula (14) are shown in Table 14 below.

Table 14

| No. | $R_{22}$ | $R_{23}$ | $X_2$ |
|---|---|---|---|
| M-14-1 | H | H | O |
| M-14-2 | 5-$CH_3$ | m-$CH_3$ | O |
| M-14-3 | 4-$CH_3$ | m-$CH_3$ | O |
| M-14-4 | 5-Cl | p-Cl | O |
| M-14-5 | H | H | S |
| M-14-6 | 5-$CH_3$ | m-$CH_3$ | S |
| M-14-7 | 4-$CH_3$ | m-$C_2H_5$ | S |
| M-14-8 | 5-Cl | p-$C_2H_5$ | S |

(xv) A compound represented by the following Formula (15):

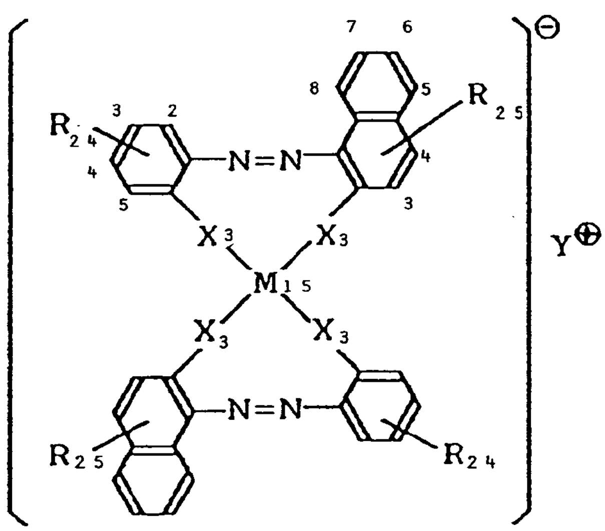

(15)

$R_{24}$ and $R_{25}$ each represent a hydrogen atom, an alkyl group, a halogen atom or a nitro group. The two $R_{24}$'s and two $R_{25}$'s may each be the same or different from each other. $X_3$ represents an oxygen atom or a sulfur atom. $M_{15}$ represents Ni. $Y^{\oplus}$ represents a quaternary ammonium cation.

Preferable examples of the compound of Formula (15) are shown in Table 15 below.

Table 15

| No. | $R_{24}$ | $R_{25}$ | $X_3$ |
|---|---|---|---|
| M-15-1 | 3-$CH_3$ | H | O |
| M-15-2 | 3-Cl | 4-$CH_3$ | O |
| M-15-3 | 4-$NO_2$ | 4-$CH_3$ | O |
| M-15-4 | H | 4-$CH_3$ | S |
| M-15-5 | 3-$NO_2$ | 4-$C_2H_5$ | S |

(xvi) A compound represented by the following Formula (16):

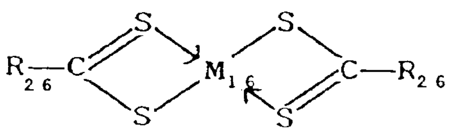

(16)

$R_{26}$ represents an amino group. $M_{16}$ represents Cu, Ni, Co or Pd.
Preferable examples of the compound of Formula (16) are shown in Table 16 below.

Table 16

| No. | $R_{26}$ | $M_{16}$ |
|---|---|---|
| M-16-1 | $(C_4H_{11})_2N$ | Ni |
| M-16-2 | $(C_5H_{11})_2N$ | Ni |

(xvii) An anthranilic acid compound represented by the following Formula (17):

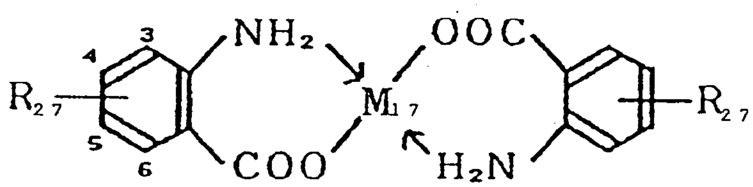

(17)

$R_{27}$ represents a hydrogen atom, a halogen atom, an alkyl group, an acyl group, a nitro group or an alkoxyl group. The two $R_{27}$'s may be the same or different from each other. $M_{17}$ represents Zn, Cu, Ni or Co.

Preferable examples of the compound of Formula (17) are shown in Table 17 below.

Table 17

| No. | $R_{27}$ | $M_{17}$ |
|---|---|---|
| M-17-1 | H | Cu |
| M-17-2 | 4-Cl | Ni |
| M-17-3 | 4-$NO_2$ | Ni |
| M-17-4 | 5-$CH_3$ | Ni |

(xviii) A bisbenzodithiol compound represented by the following Formula (18):

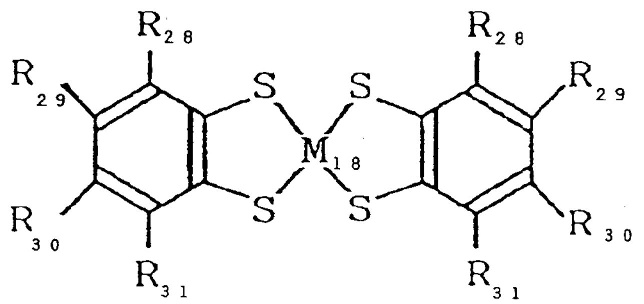

(18)

$R_{28}$ to $R_{31}$ each represent a substituted or unsubstituted alkyl group, a halogen atom, a hydrogen atom, an alkoxyl group or an amino group. The two $R_{28}$'s, two $R_{29}$'s, two $R_{30}$'s and two $R_{31}$'s may each be the same or different from each other. $M_{18}$ represents Ni, Co or Pd. In this instance, $M_{18}$ may have a negative charge and may have a counter cation.

Preferable examples of the compound of Formula (18) are shown in Table 18 below.

Table 18

| No. | $R_{28}$ | $R_{29}$ | $R_{30}$ | $R_{31}$ | $M_{18}$ |
|---|---|---|---|---|---|
| M-18-1 | H | $CH_3O$ | H | H | Ni |
| M-18-2 | H | Cl | Cl | Cl | Ni |
| M-18-3 | H | $(CH_3)_2N$ | H | H | Ni |
| M-18-4 | H | $CH_3O$ | $CH_3O$ | $CH_3O$ | Ni |
| M-18-5 | Cl | Cl | H | H | Co |
| M-18-6 | H | $CH_3O$ | H | H | Pd |
| M-18-7 | H | $CH_3$ | $CH_3$ | H | Pd |
| M-18-8 | H | $CH_3$ | $CH_3$ | H | Ni |
| M-18-9 | H | $CH_3$ | H | H | Ni |

(xix) A β-diketone compound represented by the following Formula (19):

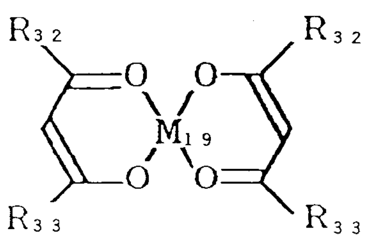

(19)

$R_{32}$ and $R_{33}$ each represent an alkyl group or an aryl group. The two $R_{32}$'s and two $R_{33}$'s may each be the same or different from each other. $M_{19}$ represents Ni.

Preferable examples of the compound of Formula (19) are shown in Table 19 below.

Table 19

| No. | $R_{32}$ | $R_{33}$ |
|---|---|---|
| M-19-1 | $CH_3$ | $CH_3$ |
| M-19-2 | $CF_3$ | $CF_3$ |
| M-19-3 | $CH_3$ | 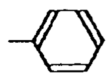 |

The silver halide used in the photosensitive material of the present invention may include silver chloride, silver bromide, silver chlorobromide, silver iodobromide and silver chloroiodobromide. These may have been subjected to chemical sensitization or spectral sensitization carried out on conventional photographic emulsions. As the chemical sensitization, sulfur sensitization, noble metal sensitization or reduction sensitization can be used. As the spectral sensitization, a method making use of hitherto well known spectral sensitizers can be applied.

The spectral sensitizer may include cyanine dyes, merocyanine dyes and trinuclear dyes. Those which can be preferably used are exemplified by 3,3′-dicarboxyethyl-2,2′-thiacarbocyanine iodide, 3,3′-diethyl-2,2′-thiacarbocyanine iodide, 3,3′-disulfoethyl-2,2′-thiacarbocyanine iodide, 3,3′-diethyl-2,2′-thiatricarbocyanine iodide, and also dyes with the following structures.

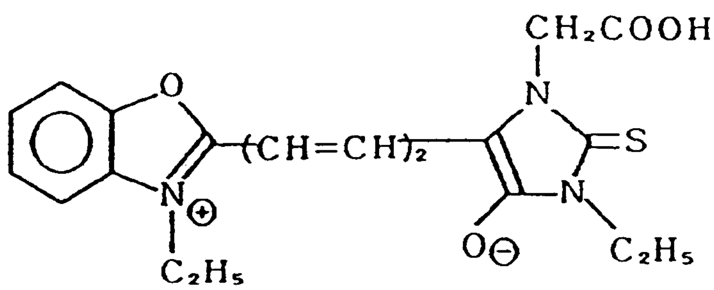

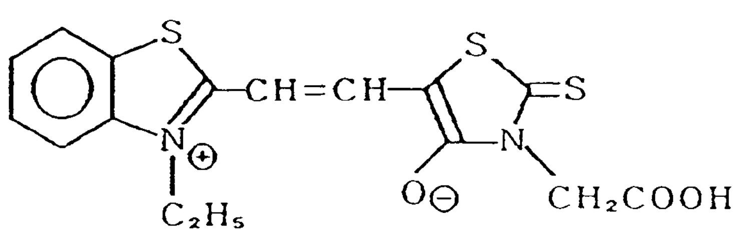

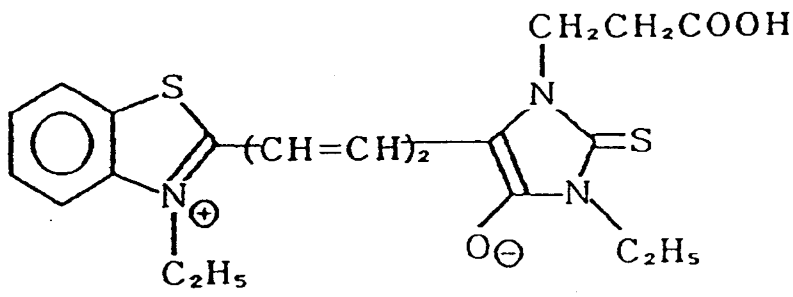

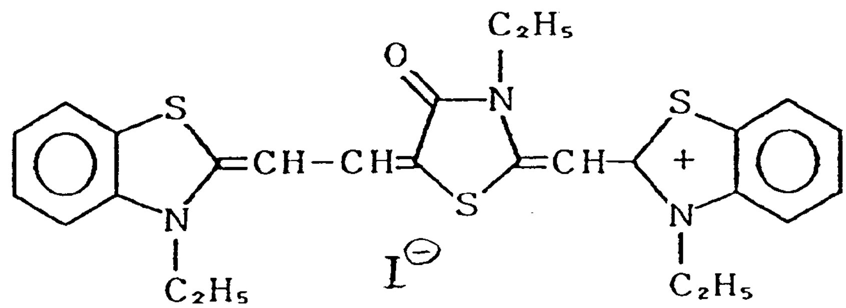

The silver halide may have a uniform halogen composition in a grain, or a multiple structure having a different halogen composition in a grain. Two or more kinds of silver halide having different halogen composition, grain size, grain size distribution, etc. may be used in combination.

As the organic silver salt, it is possible to use organic acid silver salts and triazole silver salts as disclosed in SHASHIN KOGAKU NO KISO (Basic Photographic Engineering), First Edition, Korona-sha Co., Japan Photographic Society, 1982, The Volume of Non-silver salts, p.247, or Japanese Patent Application Laid-open No. 59-55429. It is preferred to use silver slats with a low photosensitivity. They may include, for example, silver salts of aliphatic carboxylic acids, aromatic carboxylic acids, thiocarbonyl compounds having a mercapto group or α-hydrogen, and imino group-containing compounds.

The aliphatic carboxylic acids may include acetic acid, butyric acid, succinic acid, sebacic acid, adipic acid, oleic acid, linolic acid, lenolenic acid, tartaric acid, palmitic acid, stearic acid, behenic acid and camphor acid. In general, silver salts having a smaller number of carbon atoms are proportionally not stabler, and hence those having an appropriate number of carbon atoms (e.g., those having 16 to 26 carbon atoms) are preferred.

The aromatic carboxylic acids may include benzoic acid derivatives, quinolinic acid derivatives, naphthalene carboxylic acid derivatives, salicylic acid derivatives, gallic acid, tannic acid, phthalic acid, phenyl acetic acid derivatives, and pyromellitic acid.

The thiocarbonyl compounds having a mercapto group or a-hydrogen may include 3-mercapto-4-phenyl-1,2,4-triazole, 2-mercaptobenzoimidazole, 2-mercapto-5-aminothiadiazole, 2-mercaptobenzothiazole, S-alkylthioglycolic acid (alkyl group carbon atom number of 12 to 23), dithiocarboxylic acids such as dithioacetic acid, thioamides such as thiostearoamide; 5-carboxy-1-methyl-2-phenyl-4-thiopyridine, mercaptotriazine, 2-mercaptobenzoxazole, mercaptooxadiazole, 3-amino-5-benzylthio-1,2,4-triazole, and mercapto compounds disclosed in U.S. Patent No. 4,123,274.

The compounds having an imino group may typically include benzotriazole or derivatives thereof, described in Japanese Patent Publication No 44-30270 or No. 45-18416, as exemplified by benzotriazole, alkyl-substituted benzotriazoles such as methylbenzotriazole, halogen-substituted benzotriazoles such as 5-chlorobenzotriazole, carboimidobenzotriazoles such as butylcarboimidobenzotriazole, nitrobenzotriazoles as disclosed in Japanese Patent Application Laid-open No. 58-118639, sulfobenzotriazole, carboxybenzotriazole or salts thereof, or hydroxybenzotriazole, disclosed in Japanese Patent Application Laid-open No. 58-115638, 1,2,4-triazole, disclosed in U.S. Patent No. 4,220,709, or 1H-tetrazole, carbazole, saccharin, imidazole and derivatives thereof.

The reducing agent used in the present invention is a compound capable of reducing the organic silver salt to form metallic silver, upon exposure and heating of the heat-developable photosensitive material of the present invention. The reducing agent, when used, should be appropriately selected depending on the type of the organic silver salt used.

Reducing agents preferably used when the aliphatic silver salts are used as the organic silver salt may include those of the following groups (A) to (G).

(A) O-Bisphenols such as 2,2′-methylenebis(4-methyl-6-t-butylphenol), 2,2′-methylenebis(4-ethyl-6-t-butylphenol), 2,2′-methylenebis(4,6-di-t-butylphenol), 2,2′-methylenebis(4,6-dimethylphenol), 2,2′-(3,5,5-trimethylpentylidene)-bis(4,6-dimethylphenol), and 2,2′-(3,5,5-trimethylpentylidene)-bis(4,6-di-t-butylphenol).

(B) p-Bisphenols such as 4,4′-methylenebis(2,6-di-t-butylphenol), 4,4′-methylenebis(2-methyl-6-t-butylphenol), 4,4′-butylidenebis(2,6-di-t-butylphenol), 2,6-di-t-butyl-4-(3,5-dimethyl-4-hydroxybenzyl)phenol, 2,6-di-t-butyl-4-(3,5-diethyl-4-hydroxybenzyl)phenol, 2,6-di-t-butyl-4-(3,5-dimethoxy-4-hydroxybenzyl)phenol, 4,4′-benzylidenebis(2-methyl-6-t-butylphenol), and 4,4′-benzylidenebis(2-methyl-6-cylclohexylphenol).

(C) Phenols such as hydroquinone monomethyl ether, p-aminophenol, propyl gallate, hydroquinone, and 2,6-dichloro-4-benzenesulfonamidophenol.

(D) Binaphthols such as 1,1′-bi-2-naphthol and 1,1′-bi-4-methyl-2-naphthol.

(E) Bisnaphthols such as 4,4′-methylenebis(2-methyl-1-naphthol), 4,4′-methylenebis(2-ethyl-1-naphthol), and 4,4′-ethylidenebis(2-methyl-1-naphthol).

(F) Naphthols such as 1-naphthol, 4-chloro-1-naphthol, 4-methyl-1-naphthol, 4-methoxyl-1-naphthol, 2-ethyl-4-p-hydroxybenzylnaphthol, and 2-ethyl-4-p-tolylmethylnaphthol.

(G) Naphthylmethylphenols such as 2,6-dimethyl-4(4-hydroxy-3-methylnaphthylmethyl)phenol, 2,6-diethyl-4-(4-hydroxy-3-methylnaphthylmethyl)phenol, 2,6-di-t-butyl-4-(4-hydroxy-3-methylnaphthylmethyl)phenol, 2,6-dimethyl-4-(4-hydroxynaphthylmethyl)phenol, and 2-methyl-6-t-butyl-4-(4-hydroxy-3-methylnaphthylmethyl) phenol.

Reducing agents preferably used when the benzotriazole silver salts are used as the organic silver salt may include those of the following groups (H) and (I).

(H) Pyrazolidones such as 1-phenol-3-pyrazolidone.

(I) Ascorbic acids such as ascorbic acid and ascorbic acid monoester.

The photosensitive material of the present invention may optionally contain a tone modifier as an additive. The tone modifier is used when the metallic silver produced as a result of reduction should be blackened. Effective tone modifiers depend on the types of the organic silver salt and reducing agent used. Most commonly available tone modifiers can be exemplified by phthalazinones, oxazinediones, cyclic imides, urazoles, 2-pyrazolin-5-ones, quinazolines, N-hydroxynaphthalimides, uracils, phthalazinediones and thiazolinediones.

A binder may also be appropriately contained in the photosensitive material of the present invention for the purpose of improving film forming properties and dispersibility.

The binder may include cellulose esters as exemplified by nitrocellulose, cellulose phosphate, cellulose sulfate, cellulose acetate, cellulose propionate, cellulose butyrate, cellulose myrystate, cellulose palmitate, cellulose acetate propionate, and cellulose acetate-butyrate; cellulose esters as exemplified by methyl cellulose, ethyl cellulose, propyl cellulose, and butyl cellulose; vinyl resins as exemplified by polystyrene, polyvinyl chloride, polyvinyl acetate, polyvinyl butyral, polyvinyl acetal, polyvinyl alcohol, and polyvinyl pyrrolidone; copolymer resins as exemplified by a styrene/butadiene copolymer, a styrene/acrylonitrile copolymer, a styrene/butadiene/acrylonitrile copolymer, and a vinyl chloride/vinyl acetate copolymer; acrylic resins as exemplified by polymethyl methacrylate, polymethyl acrylate, polybutyl acrylate, polyacrylic acid, polymethacrylic acid, polyacrylamide, and polyacrylonitrile; polyesters as exemplified by polyethylene terephthalate; polyacrylate resins as exemplified by poly(4,4′-isopropylidene,diphenylene-co-1,4-cyclohexylenedimethylene carbonate), poly(ethylenedioxy-3,3′-phenylene thiocarbonate), poly(4,4′-isopropylidene,diphenylene carbonate-co-terephthalate), poly(4,4′-isopropylidene,diphenylene carbonate), poly(4,4′-sec-butylidene,diphenylene carbonate), and poly(4,4′-isopropylidene,diphenylene carbonate-block-oxyethylene); polyamides; polyimides; epoxy resins; phenol resins; polyolefins as exemplified by polyethylene, polypropylene, and chlorinated polyethylene; and natural,polymers such as gelatin.

In addition, an antifoggant, an alkali agent, a surface active agent etc. may also be added to the photosensitive layer in the present invention.

The above components in the photosensitive layer in the present invention may preferably be mixed in the following proportions.

The organic silver salt used may preferably be in an amount of from 0.3 $g/m^2$ to 30 $g/m^2$, particularly preferably 0.7 $g/m^2$ to 15 $g/m^2$, and more preferably 1.2 $g/m^2$ to 8 $g/m^2$.

The photosensitive silver halide should preferably be contained in an amount of from 0.001 mol to 2 mols, and more preferably from, 0.05 mol to 0.4 mol, per mol of the organic silver salt. In the present invention, the silver halide may be replaced with a silver halide forming agent as exemplified by halogen compounds such as tetrabutyl ammonium bromide, N-bromosuccinimide, bromine or iodine. In this instance, the silver halide forming agent may be in the same amount as in the case of the silver halide. The reducing agent should preferably be contained in an amount of from 0.05 mol to 3 mols, and more preferably from 0.2 mol to 1.3 mols,

per mol of the organic silver salt.

The metal chelate compound may preferably be mixed in an amount of from 0.00001 mol to 0.5 mol, more preferably from 0.0001 mol to 0.05 mol, and particularly preferably from 0.0005 mol to 0.03 mol, per mol of the total of the organic silver salt and the silver halide or silver halide forming agent.

In the case when the tone modifier is used, it may be used in an amount ranging from about 0.0001 mol to about 2 mols, and preferably from about 0.0005 mol to about 1 mol, per mol of the organic silver salt.

As the support used in the present invention, extensively various kinds of supports can be used. Typical supports can be exemplified by cellulose nitrate films, cellulose ester films, polyvinylacetal films, polystyrene films, polyethylene terephthalate films, polycarbonate films, baryta paper, and glass sheets, paper, metal sheets or the like. The paper is suitable when a support paper having been subjected to hydrophobic treatment comprises an emulsion layer in which an organic solvent is used. It is also suitable to use paper having been sized using a polysaccharide or the like.

The heat-developable photosensitive material of the present invention may be provided with an antistatic layer or a conductive layer. It may also be incorporated with an anti-halation dye.

The heat-developable photosensitive material used in working the present invention may further optionally be incorporated with a matting agent including, for example, starch, titanium dioxide, zinc oxide and silica. It may also be incorporated with an optical whitening agent, including, for example, stilbenes, tirazines, oxazoles, and cumarin optical whitening agents.

In order to improve transparency, increase image density, improve raw stock stability of the heat-developable photosensitive material, and in some instances in order to improve heat resistance of the photosensitive material, a photosensitive material layer may optionally be provided thereon with a protective layer. The protective layer may suitably have a layer thickness of from 1 micron to 30 microns. A layer with a thickness smaller than this may have no effect stated above, and a layer with an excessively large thickness can give no particular effect, only resulting in a high cost. The protective layer may be comprised of a polymer. Suitable polymers may preferably be those being heat-resistant, colorless and soluble in solvents, and may include polyvinyl chloride, polyvinyl acetate, copolymers of vinyl chloride and vinyl acetate (preferably containing 50 mol % or more of vinyl chloride), polyvinyl butyral, polystyrene, polymethyl methacrylate,,benzyl cellulose, ethyl cellulose, cellulose acetatebutyrate, cellulose diacetate, cellulose triacetate, polyvinylidene chloride, chlorinated polypropylene, polyvinlypyrrolidone, cellulose propionate, polyvinyl formal, cellulose acetate butyrate, polycarbonate, and cellulose acetate propionate. It may also include gelatin, gelatin derivatives such as phthalated gelatin, acrylamide polymers, polyisobutylene, a butadiene-styrene copolymer (with any desired monomer ratio), and polyvinyl alcohol.

Preferable polymers are those having a heat resistance of 115°C or above, a refactive index of 1.45 or more at 20°C.

The heat-developable photosensitive material of the present invention may have the photosensitive layer, conductive layer, protective layer, etc. having been respectively individually formed, in the case of which each of these layers can be provided by various coating processes. Coating processes that form the respective layers can be exemplified by dipping, air-knife coating, curtain coating, and extrusion coating making use of a hopper as disclosed in U.S. Patent No. 2,681,294. If necessary, two or more layers can be simultaneously coated.

The heat-developable photosensitive material of the present invention is subjected to imagewise exposure and heating (heat development), where the organic silver salt and the reducing agent react at the exposed area to cause oxidation-reduction reaction, and the metallic silver produced as a result of the reaction forms a blackened image.

The metal chelate compound contained in the heat-developable photosensitive material of the present invention contributes an improvment in the sensitivity of the photosensitive layer and an improvement in the storage stability. Although it is unclear how the metal chelate compound behaves, it is presumed that the compound is incorporated into crystals of the organic silver salt or silver halide to achieve an improvement in the sensitivity of the photosensitive layer and an improvement in the storage stability.

The heat-developable photosensitive material of the present invention can also form a pattern corresponding with the difference in light-absorption, utilizing light-absorbing properties of an oxidized product formed by the oxidation-reduction reaction (a product by oxidation of the reducing agent). More specifically, light with a specific wavelength is absorbed at the area where the oxidized product has been formed (an imagewise exposed area) and light is less absorbed at the area where no oxidized product has been formed (an imagewise unexposed area). Thus there are differences in light-absorbing properties, and a pattern corresponding therewith can be formed.

Utilizing the light-absorbing properties of the oxidized product, it is also possible for the heat-developable photosensitive material of the present invention to form a pattern comprised of a polymerized area and an unpolymerized area (hereinafter "polymerized-unpolymerized pattern"). That is, the photosensitive layer

according to the present invention may be incorporated with a polymerizable polymer precursor and a photopolymerization initiator, followed by exposure, heating (heat development) and polymerization exposure, so that the polymerized-unpolymerized pattern can be formed. The mechanism by which the polymerized-unpolymerized pattern is formed is that in the area where the oxidized product has been formed no polymerization proceeds because of the light absorption attributable to the oxidized product, and in the area where the oxidized product has been formed the polymerization proceeds.

The polymerizable polymer precursor and the photopolymerization initiator may be contained in the photosensitive layer. Alternatively, a polymerizing layer containing the polymerizable polymer precursor and photopolymerization initiator may be provided separately from the photosensitive layer. The photosensitive layer and the polymerizing layer may be formed in laminae in the order of the polymerizing layer and the photosensitive layer from the support side, or in the order of the photosensitive layer and the polymerizing layer from the support side. Alternatively, they may hold a support between them, one side of which the photosensitive layer is provided and the other side of which the polymerizing layer is provided.

The photopolymerization initiator used in the photosensitive material of the present invention includes, for example, carbonyl compounds, sulfur compounds, halogen compounds, photopolymerization initiators of a redox type, and initiators of a peroxide type sensitized with a dye such as pyrylium.

Stated specifically, the carbonyl compounds may include diketones as exemplified by benzyl, 4,4′-dimethoxybenzyl, diacetyl, and camphorquinone; benzophenones as exemplified by 4,4′-bis(diethylamino)benzophenone, and 4,4′-dimethoxybenzophenone; acetophenones as exemplified by acetophenone, and 4-methoxyacetophenone; benzoin alkyl ethers; thioxanthones as exemplified by 2-chlorothioxanthone, 2,4-dichlorothioxanthone, 2,4-diethylthioxanthone, and thioxanthone-3-carboxylic acid-β-methoxy ethyl ester; chalcones and styrylketones having a dialkylamino group; and cumarines as exemplified by 3,3′-carbonylbis(7-methoxycumarine), and 3,3′-carbonylbis(7-diethylaminocumarine).

The sulfur compounds include, for example, dibenzothiazolyl sulfide, decylphenyl sulfide, and disulfides.

The halogen compounds include, for example, carbon tetrabromide, quinolinesulfonyl chloride, and S-triazines having a trihalomethyl group.

The photopolymerization initiators of redox type include those used in combination of a trivalent iron ionic compound (as exemplified by ferric ammonium citrate) with a peroxide, and those used in combination of a photoreducing coloring matter such as riboflavin or Methylene Blue with a reducing agent such as triethanolamine or ascorbic acid.

In the photopolymerization initiator described above (including the sensitizer), two or more photopolymerization initiators can also be used in combination to effect a more efficient photopolymerization reaction.

Such combination of the photopolymerization initiators includes a combination of chalcones having a dialkylamino group and styrylketones or cumarins, with S-triazines having a trihalomethyl group or camphorquinone.

As the polymerizable polymer precursor used in the photosensitive material of the present invention, a compound having at least one reactive vinyl group in its molecule can be utilized.

The reactive vinyl group in these compounds may include substituted or unsubstituted vinyl groups having polymerization reactivity, as exemplified by styrene vinyl groups, acrylic acid vinyl groups, methacrylic acid vinyl groups, allyl vinyl groups, and vinyl ethers, as well as ester vinyl groups such as vinyl acetate.

Specific examples of the polymerizable polymer precursor satisfying such conditions are as follows.

They may include monovalent monomers as exemplified by styrene, methylstyrene, chlorostyrene, bromostyrene, methoxystyrene, dimethylaminostyrene, cyanostyrene, nitrostyrene, hydroxystyrene, aminostyrene, carboxystyrene, acrylic acid, methyl acrylate, ethyl acrylate, cyclohexyl acrylate, acrylamide, methacrylic acid, methyl methacrylate, ethyl methacrylate, propyl methacrylate, butyl methacrylate, phenyl methacrylate, cyclohexyl methacrylate, vinyl pyridine, N-vinylpyrrolidone, N-vinylimidazole, 2-vinylimidazole, N-methyl-2-vinylimidazole, propyl vinyl ether, butyl vinyl ether, isobutyl vinyl ether, β-chloroethyl vinyl ether, phenyl vinyl ether, p-methylphenyl vinyl ether, and p-chlorophenyl vinyl ether; divalent monomers as exemplified by divinylbenzene, distyryl oxalate, distyryl malonate, distyryl succinate, distyryl glutarate, distyryl adipate, distyryl maleate, distyryl fumarate, distyryl β,β′-dimethylglutarate, distyryl 2-bromoglutarate, distyryl α,α′-dichloroglutarate, distyryl terephthalate, oxalic acid di(ethyl acrylate), oxalic acid di(methyl acrylate), malonic acid di(ethyl acrylate), malonic acid di(methyl ethyl acrylate), succinic acid di(ethyl acrylate), glutaric acid di(ethyl acrylate), adipic acid di(ethyl acrylate), maleic acid di(ethyl acrylate), fumaric acid di(ethyl acrylate), β,β′-dimethylglutaric acid di(ethyl acrylate) , ethylenediacrylamide, propylenediacrylamide, 1,4-phenylenediacrylamide, 1,4-phenylenebis(oxyethyl acrylate), 1,4-phenylenebis(oxymethyl ethyl acrylate), 1,4-bis(acryloyloxyethoxy)cyclohexane, 1,4-bis-(acryloyloxymethylethoxy)cyclohexane, 1,4-bis-(acryloyloxyethoxycarbamoyl) benzene, 1,4-bis-(acryloyloxymethylethoxycarbamoyl)benzene, 1,4-bis-(acryloyloxyethoxycarbamoyl)cyclohexane, bis(acryloyloxyethoxycarbamoylcyclohexyl)methane, oxalic acid di(ethyl methacrylate), oxalic acid

di(methyl ethyl methacrylate), malonic acid di(ethyl methacrylate), malonic acid di(methyl ethyl methacrylate), succinic acid di(ethyl methacrylate), succinic acid di(methyl ethyl methacrylate), glutaric acid di(ethyl methacrylate), adipic acid di(ethyl methacrylate), maleic acid di(ethyl methacrylate), fumaric acid di(ethyl methacrylate), fumaric acid di(methyl ethyl methacrylate), β,β'-dimethylglutaric acid di(ethyl methacrylate), 1,4-phenylenebis(oxyethyl methacrylate), and 1,4-bis(methacryloyloxyethoxy) cyclohexane acryloyloxyethoxyethyl vinyl ether; trivalent monomers as exemplified by pentaerythritol triacrylate, pentaerythritol trimethacrylate, pentaerythritol tri(hydroxystyrene), dipentaerythritol hexaacrylate, cyanuric acid triacrylate, cyarnuric acid trimethacrylate, 1,1,1-trimethylolpropane triacrylate, 1,1,1-trimethylolpropane trimethacrylate, cyanuric acid tri-(ethyl acrylate), 1,1,1-trimethylolpropane tri(ethyl acrylate), cyanuric acid tri(ethyl vinyl ether), a condensate of 1,1,1-trimethylolpropane(toluenediisocyanate) with hydroxyethyl acrylate, and a condensate of 1,1,1-trimethylolpropanetri(hexanediisocyanate) with p-hydroxystyrene; tetravalent monomers as exemplified by ethylenetetraacrylamide, and propylenetetraacrylamide; and hexavalent monomers such as dipentaerythritol hexaacrylate.

The above polymerizable polymer precursors may be used in combination of two or more kinds.

In the instance where the polymerizable polymer precursor and the photopolymerization initiator are contained in the heat-developable photosensitive material of the present invention, the photopolymerization initiator may preferably be contained in an amount of from 0.01 mol to 10 mols, and more preferably from 0.5 mol to 3.0 mols, per mole of the reducing agent. The photopolymerization initiator should preferably be in an amount of from 0.1 part by weight to 30 parts by weight, and more preferably from 0.5 part by weight to 10 parts by weight, based on 100 parts by weight of the polymerizable polymer precursor.

In the present invention, the photosensitive layer may preferably have a thickness of from 0.1 μm to 50 μm, more preferably from 1 μm to 30 μm, and particularly preferably from 2 μm to 20 μm. In the case when the polymerizing layer is provided separately from the photosensitive layer, the polymerizing layer may have the thickness in the same range as the range of the thickness of the photosensitive layer.

As light sources used in the steps of imagewise exposure and polymerization exposure, usable are, for example, sunlight, tungsten lamps, mercury lamps, halogen lamps, xenon lamps, fluorescent lamps, LEDs, and lasers, and the wavelength of the light used in these steps may be the same or different. Even if the light having the same wavelength is used, the latent image can be sufficiently written with use of light having an intensity of the level that does not cause photopolymerization in the step of imagewise exposure, since the silver halide usually has a sufficiently higher photosensitivity than the photopolymerization initiator. For example, in the step of imagewise exposure, the exposure may be carried out using light that may give about 1 $mJ/cm^2$ or less at the surface of the photosensitive material. In the step of polymerization exposure, the exposure may be carried out using light that may give about 500 $mJ/cm^2$ or less at the surface of the photosensitive material.

Various kinds of means are available as a means of heat-developing the photosensitive material of the present invention. For example, the photosensitive material may be brought into contact with a simple heating plate. Alternatively, it may be brought into contact with a heated drum. In some instances, it may also be passed through a heated space. It may also be heated by high-frequency heating or using laser beams. It is suitable to carry out the heating at a temperature of from 80°C to 160°C, preferably from 100°C to 160°C, and more preferably from 110°C to 140°C. The heating time may be elongated or shortened, whereby a higher temperature or lower temperature within the above range can be used. Developing time may be usually from about 1 second to about 60 seconds, and preferably form 3 seconds to 20 seconds.

The heat-developable photosensitive material of the present invention, constituted as described above, has a good sensitivity. Hence, according to the photosensitive material of the present invention, the photographic processing time can be shortened, and also an image with a high γ (gamma), that is, an image with a low fog density and a high density in the image area can be obtained. The heat-developable photosensitive material of the present invention also has a superior raw stock stability.

The present invention will be described below in greater detail by giving Examples. In the following, "part(s)" indicates "part(s) by weight".

## Example 1

A dispersion with the following composition was prepared using a homomixer under safelight.

| | |
|---|---|
| Polyvinyl butyral | 3.0 parts |
| Silver behenate | 2.5 parts |
| Silver bromide | 0.4 part |
| Behenic acid | 1.0 part |
| Homophthalic acid | 0.3 part |
| Phthalazinone | 0.5 part |
| 2,6-Di-t-butyl-4-(3,5-dimethyl-4-hydroxybenzyl)phenol | 2.0 parts |
| Xylene | 30 parts |
| n-Butanol | 30 parts |

To this dispersion, a solution obtained by dissolving in 4.0 parts of dichloroethane 0.025 part of the metal chelate compound No. M-7-6 shown in Table 7 previously set out (MIR-102; available from Midori Kagaku Co., Ltd.) was added to give a photosensitive material dispersion. This photosensitive material dispersion was coated on a 12 μm thick polyethylene terephthalate (PET) film in a dried-coating thickness of 5 μm to form a photosensitive layer.

On this photosensitive layer, a protective layer containing colloidal silica and polyvinyl alcohol was provided in a dried-coating thickness of 2 μm. The heat-developable photosensitive material A of the present invention was thus prepared.

On the other hand, heat-developable photosensitive material B was prepared in the same manner as the heat-developable photosensitive material A except that no metal chelate compound was used.

To each photosensitive layer of both the photosensitive materials A and B, a step tablet was superposed, which were then exposed to light for 10 seconds using a tungsten lamp, followed by heating for 10 seconds using a drum type heater adjusted to 127°C. The tungsten lamp was in an intensity of 1,000 lux at the surface of the step tablet.

On each of the photosensitive materials A and B thus exposed and heated, optical density at 400 nm was measured to obtain photosensitivity performance as shown in Fig. 1. The optical density was measured using a spectrophotometer UV-3100S, manufactured by Shimadzu Corporation.

As is seen from Fig. 1, although the photosensitive material B shows a performance tolerable enough for practical use, the photosensitive material A has a better rise sensitivity and much higher optical density than the photosensitive material B.

## Example 2

A dispersion with the following composition was prepared using a homomixer under safelight.

| | |
|---|---|
| Polymethyl methacrylate | 2.5 parts |
| Silver behenate | 2.5 parts |
| Silver iodobromide (Br/I = 90/10) | 0.4 part |
| Behenic acid | 1.5 parts |
| Azelaic acid | 0.3 part |
| Phthalazine | 0.2 part |
| Phthalic acid | 0.2 part |
| 2,6-Dichloro-4-benzenesulfonamidophenol | 1.8 parts |
| Xylene | 25 parts |
| n-Butanol | 30 parts |

Next, to this dispersion, a solution obtained by dissolving in 2.0 parts of dichloroethane 0.01 part of the metal chelate compound No. M-16-1 shown in Table 16 previously set out (ANTIGEN NBC; available from Sumitomo Chemical Co., Ltd.) was added to give a dispersion. To this dispersion, a solution obtained by dissolving 0.005 part of 3,3′-diethyl-2,2′-thiatricarbocyanine iodide in 1.5 parts of N,N-dimethylformamide was added, followed by sensitization to give a photosensitive material dispersion.

This photosensitive material dispersion was coated on a 100 μm thick baryta paper in a dried-coating thickness of 10 μm using an applicator to form a photosensitive layer. On the photosensitive layer thus formed, the same protective layer as in Example 1 was provided in a dried-coating thickness of 2 μm. The heat-developable photosensitive material C of the present invention was thus prepared.

On the other hand, heat-developable photosensitive material D was prepared in the same manner as the heat-developable photosensitive material C except that no metal chelate compound was used.

Each of the heat-developable photosensitive materials C and D thus prepared was subjected to imagewise exposure and heat development, and optical density at imagewise exposed areas and optical density at imagewise unexposed areas were measured. The optical density was measured on photosensitive materials C and D before fastness tests and on photosensitive materials C and D after fastness tests. Results of measurement are shown in Table 20.

The imagewise exposure was carried out at an image-surface illuminance of 30 $\mu J/cm^2$ using a 780 nm semiconductor laser.

The heat development (heating) was carried out at a temperature of 115°C for 10 seconds.

The optical density was measured using a Macbeth reflection densitometer.

To make the fastness test, the photosensitive materials C and D were left to stand for 72 hours in a durability tester kept at a temperature of 45°C and a humidity of 80 % RH.

Table 20

| Photosensitive material | Optical density before fastness test (imagewise exposed area/imagewise unexposed area) | Optical density after fastness test (imagewise exposed area/imagewise unexposed area) |
|---|---|---|
| C | 1.85/0.10 | 1.65/0.13 |
| D | 1.72/0.10 | 1.32/0.27 |

As is seen from Table 20, although the photosensitive material B has a good raw stock stability and is tolerable enough for practical use, the photosensitive material C has a better raw stock stability than the photosensitive material D. More specifically, the photosensitive material C has a higher optical density at imagewise exposed areas both before the fastness test and after the fastness test and also a lower optical density at imagewise unexposed areas after the fastness test.

Example 3

A dispersion with the following composition was prepared using a homomixer under safelight.

| | |
|---|---|
| Polyvinyl butyral | 6.0 parts |
| Silver behenate | 5.0 parts |
| Silver bromide | 0.5 part |
| Behenic acid | 3.0 part |
| Stearic acid | 1.0 part |
| 7-Methoxybenzoxazinedione | 0.6 part |
| 2,6-Di-t-butyl-4-(3,5-dimethyl-4-hydroxybenzyl)phenol | 4.0 parts |
| Xylene | 60 parts |
| n-Butanol | 60 parts |

Next, to this dispersion, a solution obtained by dissolving in 1 part of N,N-dimethylformamide 0.001 part of spectral sensitizer represented by the following formula (A) was added. To 14 parts of the dispersion thus prepared, a solution obtained by dissolving in 0.5 part of dichloroethane 0.0011 part of the metal chelate compound No. M-3-3 shown in Table 3 previously set out was added to give a photosensitive material dispersion.

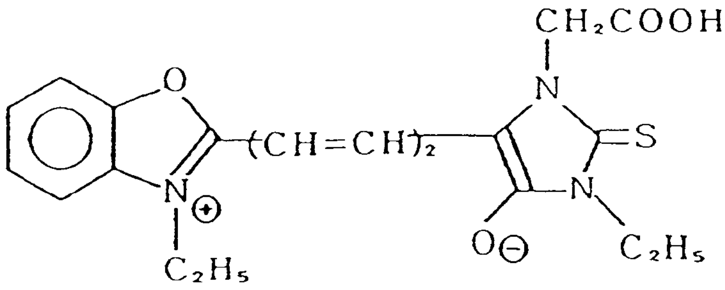

(A)

Except for use of this photosensitive material dispersion, heat-developable photosensitive material E of the present invention was prepared in the same manner as in Example 1. Heat-developable photosensitive material F of the present invention was also prepared in the same manner as the photosensitive material E except that 0.0011 part of the metal chelate compound No. M-3-3 used therein was replaced with 0.0016 part of the metal chelate compound No. M-7-7 shown in Table 7 previously set out.

Heat-developable photosensitive material G of the present invention was also prepared in the same manner as the photosensitive material E except that 0.0011 part of the metal chelate compound No. M-3-3 used therein was replaced with 0.0013 part of the metal chelate compound No. M-8-4 shown in Table 8 previously set out.

Heat-developable photosensitive material H of the present invention was still also prepared in the same manner as the photosensitive material E except that 0.0011 part of the metal chelate compound No. M-3-3 used therein was replaced with 0.003 part of the metal chelate compound No. M-18-6 shown in Table 18 previously set out.

On the other hand, heat-developable photosensitive material I was prepared in the same manner as the heat-developable photosensitive material E except that no metal chelate compound was used.

The photosensitive materials E, F, G, H and I were each exposed to light using a 633 nm He-Ne laser, at a beam size of 25 μm x 25 μm for an exposure time of 35 μsec per dot, followed by heating at 132°C for 10 seconds. The exposure was carried out at an image-surface illuminance of 20 $\mu J/cm^2$

On each of the photosensitive materials E, F, G, H and I thus exposed and heated, optical density at 400 nm at imagewise exposed areas-was measured to obtain the results as shown in Table 21. The optical density was measured using a spectrophotometer UV-3100S, manufactured by Shimadzu Corporation.

The photosensitive materials E, F, G, H and I were also each subjected to heat development to measure exposure energy required when the optical density at imagewise exposed areas comes to be "optical density at imagewise unexposed areas + 1.0". For this measurment, imagewise exposure was carried out using the He-Ne laser described above. Heating was carried out under conditions of 132°C for 10 seconds. Results of measurement are shown in Table 22.

The measured values shown in Table 21 show optical densities obtained on the respective photosensitive materials when the imagewise exposure and heat development were carried out under the same conditions.

As for the measured values shown in Table 22, they show exposure energies required for attaining the same optical densities on the respective photosensitive materials. The lower the value is, the better sensitivity the photosensitive material has. Stated with reference to the graph of Fig. 1, the better rise performance the photosensitive material shows, the lower the value shown in Table 22 is.

Table 21

| Photosensitive material | Optical density |
|---|---|
| E | 4.81 |
| F | 4.45 |
| G | 4.76 |
| H | 3.94 |
| I | 3.23 |

Table 22

| Photosensitive material | Exposure energy |
|---|---|
| | $\mu J/cm^2$ |
| E | 3.5 |
| F | 3.7 |
| G | 3.1 |
| H | 3.4 |
| I | 4.8 |

As is seen from Tables 21 and 22, although the photosensitive material I is tolerable enough for practical use, the photosensitive materials E, F, G and H each have a much better sensitivity.

Example 4

Heat-developable photosensitive material J of the present invention was prepared in the same manner as the photosensitive material A of Example 1 except that 0.025 part of the metal chelate compound No. M-7-6 used therein was replaced with 0.020 part of the metal chelate compound No. M-1-5 shown in Table 1 previously set out.

Heat-developable photosensitive material K of the present invention was also prepared in the same manner as the photosensitive material A of Example 1 except that 0.025 part of the metal chelate compound No. M-7-6 used therein was replaced with 0.018 part of the metal chelate compound No. M-4-1 shown in Table 4 previously set out.

Heat-developable photosensitive material L of the present invention was also prepared in the same manner as the photosensitive material A of Example 1 except that 0.025 part of the metal chelate compound No. M-7-6 used therein was replaced with 0.023 part of the metal chelate compound No. M-14-6 shown in Table 14 previously set out.

The photosensitive material J, K and L thus obtained were each subjected to imagewise exposure and heat development in the same manner as in Example 1, and thereafter optical density at 400 nm was measured in the same manner as in Example 1. Results of measurement are shown in Fig. 2.

As is seen from Fig. 2, the photosensitive materials J, K and L each show the same good rise sensitivity and high optical density as the photosensitive material A.

Example 5

A dispersion with the following composition was prepared using a homomixer under safelight.

| | |
|---|---|
| Polyvinyl butyral | 1.9 parts |
| Silver behenate | 2.5 parts |
| Silver bromide | 0.2 part |
| Behenic acid | 0.5 part |
| Azelaic acid | 0.2 part |
| Phthalazinone | 0.25 part |
| 2-Ethyl-4-p-hydroxybenzylnaphthol | 1.6 parts |
| Xylene | 30 parts |
| n-Butanol | 20 parts |

To this dispersion, a solution obtained by dissolving in 0.1 part of dichloroethane 0.002 part of the metal chelate compound No. M-18-2 shown in Table 18 previously set out was added to give a photosensitive material dispersion. This photosensitive material dispersion was coated on a 6 μm thick PET film in a dried-coating thickness of 4 μm to form a photosensitive layer. On this photosensitive layer, a 2 μm thick layer of polyvinyl alcohol was provided. On the side opposite to the side on which the photosensitive layer was formed, the PET film was previously provided with a 6 μm thick polymerizing layer. This polymerizing layer was composed of 1.75 parts of ARONIX M 6300 (trade name; available from Toagosei Chemical Industry Co., Ltd.), 2.25 parts of polyester resin (trade name: VYLON #200; available from Toyobo Co., Ltd.), 0.2 part of chlorinated rubber (510; available from Sanyo-Kokusaku Pulp Co., Ltd.), 0.37 part of 2,4-diethylthioxanthone and 0.37 part of p-diethylaminobenzoate.

A copper sheet was laminated to this polymerizing layer to give heat-developable photosensitive material M of the present invention.

Separately from this photosensitive material, heat-developable photosensitive material N was prepared in the same manner as in the heat-developable photosensitive material M except that the metal chelate compound used therein was not contained.

A mask was superposed to the photosensitive layer of each of both the photosensitive materials, followed by imagewise exposure using a tungsten lamp, at 1,000 lux for 10 seconds. Thereafter, the mask was removed from each photosensitive material, which was then heated for 10 seconds using a drum type heater adjusted to 105°C. Next, both the photosensitive materials were subjected to uniform polymerization exposure for 2 seconds from the side of their photosensitive layers using an ultrahigh-pressure mercury lamp (USH-500D; manufactured by Ushio Inc.). The polymerization exposure was carried out setting the ultrahigh-pressure mercury lamp set 80 cm apart from the photosensitive materials. Thereafter, for each photosensitive material M and N, the PET film was separated from the copper sheet. As a result, for each photosensitive material, the part at which the polymerizing layer had polymerized (hereinafter "polymerized areas") remained on the copper sheet, and the part at which the polymerizing layer had not polymerized (hereinafter "unpolymerized areas" remained on the PET film. The polymerized areas thus formed corresponded with the part not exposed to light at the time of imagewise exposure and the unpolymerized area corresponded with the part exposed to light at the time of imagewise exposure.

Next, photosensitive materials M and N additionally prepared were subjected to the same imagewise exposure, heat development and polymerization exposure as the above except that the exposure time for the imagewise exposure was changed to 6 seconds. Then the PET film was separated from the copper sheet. As a result, with regard to the photosensitive material M, the polymerized areas remained on the copper sheet and unpolymerized area remained on the PET film. With regard to the photosensitive material N, however, not only polymerized areas remained but also unpolymerized areas partly remained on the copper sheet, so that no pattern corresponding with the imagewise exposure was obtainable.

## Claims

1. A heat-developable photosensitive material comprising a support and provided thereon a photosensitive layer containing at least an organic silver salt, a silver halide or a silver halide forming agent, a reducing agent and a metal chelate compound.

2. The heat-developable photosensitive material according to claim 1, wherein the central metal of said metal chelate compound comprises a transition metal.

3. The heat-developable photosensitive material according to claim 2, wherein said transition metal is selected from Zn, Cu, Ni, Co, Mn, Pd and Zr.

4. The heat-developable photosensitive material according to claim 1, wherein said metal chelate compound has a ligand comprising a sulfur atom.

5. The heat-developable photosensitive material according to claim 1, wherein said metal chelate compound is contained in an amount of from 0.00001 mol to 0.5 mol per mol of the total of said organic silver salt and said silver halide or silver halide forming agent.

6. An image forming method comprising subjecting a heat-developable photosensitive material according to claim 1, to imagewise exposure and heating to form an image.

7. The heat-developable photosensitive material according to claim 1, wherein said photosensitive layer contains a polymerizable polymer precursor and a photopolymerization initiator.

8. The heat-developable photosensitive material according to claim 7, wherein the central metal of said metal chelate compound contained in said photosensitive layer comprises a transition metal.

9. The heat-developable photosensitive material according to claim 8, wherein said transition metal is selected from Zn, Cu, Ni, Co, Mn, Pd and Zr.

10. The heat-developable photosensitive material according to claim 7, wherein said metal chelate compound contained in said photosensitive layer has a ligand comprising a sulfur atom.

11. The heat-developable photosensitive material according to claim 1, comprising said photosensitive layer and further comprising a polymerizing layer containing a polymerizable polymer precursor and a photopolymerization initiator.

12. The heat-developable photosensitive material according to claim 11, wherein the central metal of said metal chelate compound contained in said photosensitive layer comprises a transition metal.

13. The heat-developable photosensitive material according to claim 12, wherein said transition metal is selected from Zn, Cu, Ni, Co, Mn, Pd and Zr.

14. The heat-developable photosensitive material according to claim 11, wherein said metal chelate compound contained in said photosensitive layer has a ligand comprising a sulfur atom.

15. An image forming method comprising subjecting a heat-developable photosensitive material according to claim 7 or 11, to imagewise exposure, heating and polymerization exposure to form an image.

F I G. 1

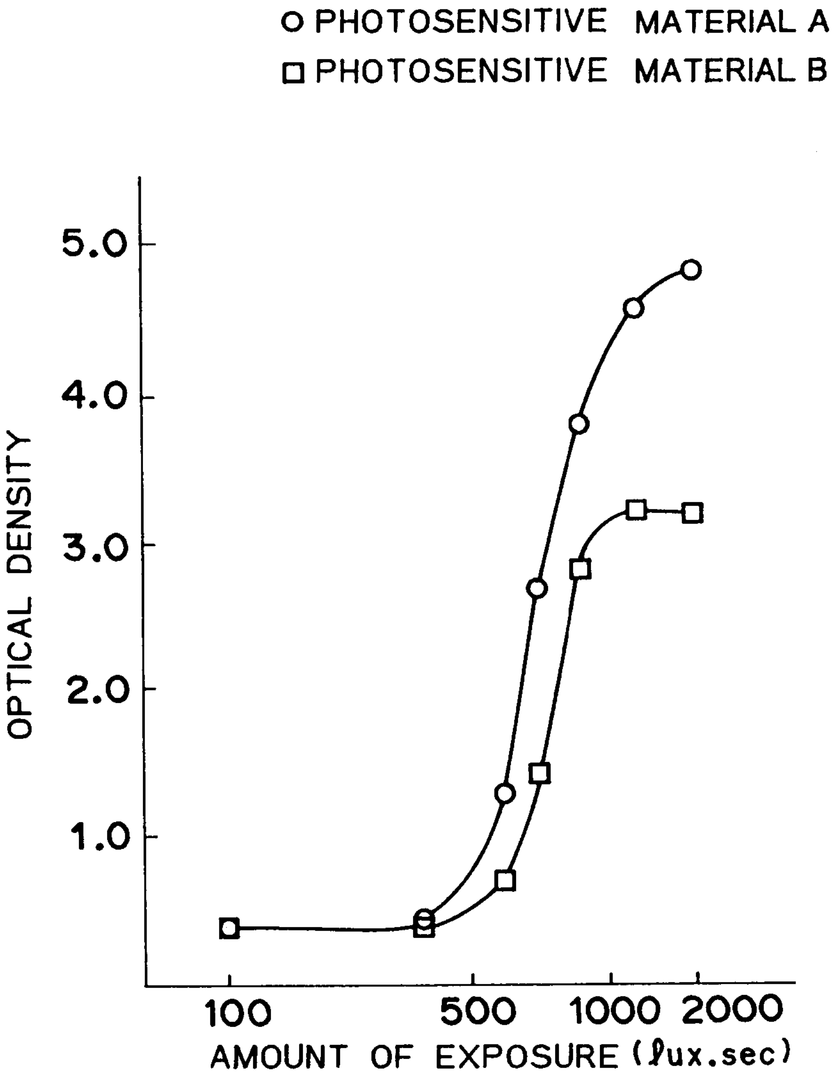
O PHOTOSENSITIVE MATERIAL A
□ PHOTOSENSITIVE MATERIAL B
OPTICAL DENSITY
5.0
4.0
3.0
2.0
1.0
100
500
1000
2000
AMOUNT OF EXPOSURE (ℓux.sec)

FIG. 2

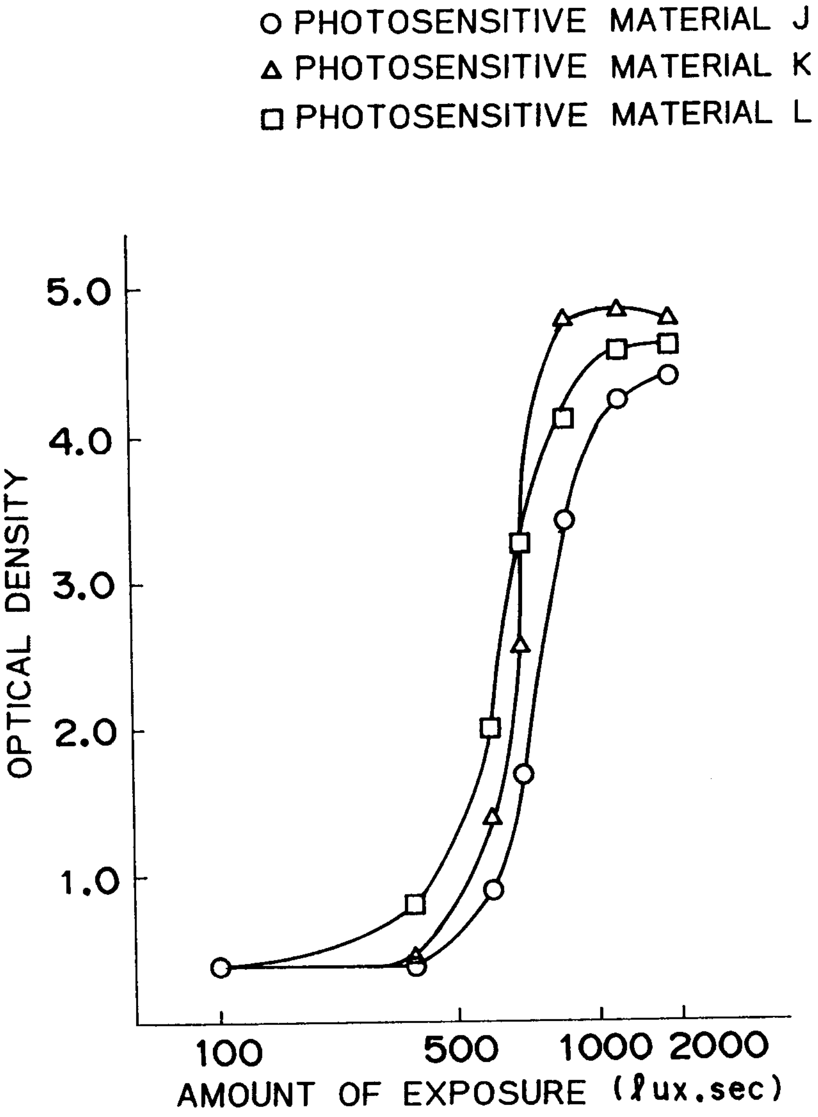
○ PHOTOSENSITIVE MATERIAL J
△ PHOTOSENSITIVE MATERIAL K
□ PHOTOSENSITIVE MATERIAL L
5.0
4.0
3.0
2.0
1.0
OPTICAL DENSITY
100
500
1000
2000
AMOUNT OF EXPOSURE (ℓux.sec)

European Patent Office

# EUROPEAN SEARCH REPORT

Application Number

EP 92 30 2314

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 128 428 (S. IKENOUE ET AL.)<br>* the whole document * | 1-6 | G03C1/498<br>G03F7/095 |
| Y | * the whole document *<br>--- | 7-15 | |
| Y | WO-A-8 805 559 (THE FOXBORO COMPANY)<br>* claims *<br>--- | 7-15 | |
| A | US-A-4 668 612 (H. HIRAI)<br>* claims; table 2 *<br>--- | 1-3 | |
| A | EP-A-0 363 790 (CANON KK)<br>* claims * | 1 | |
| D | & JP-A-3 135 564<br>----- | | |

TECHNICAL FIELDS SEARCHED (Int. Cl.5)

G03C
G03F

The present search report has been drawn up for all claims

| Place of search | Date of completion of the search | Examiner |
|---|---|---|
| BERLIN | 01 JULY 1992 | STOCK H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)